Europäisches Patentamt

European Patent Office

Office européen des brevets

(11) Numéro de publication: **0 234 152**
**A2**

# (12) DEMANDE DE BREVET EUROPEEN

(21) Numéro de dépôt: 86402821.2

(22) Date de dépôt: 16.12.86

(51) Int. Cl.⁴: **H01L 29/08** , **H01L 29/80** , **H01L 29/78** , **H01L 21/265** , **H01L 29/36**

(30) Priorité: 20.12.85 FR 8518984

(43) Date de publication de la demande:
**02.09.87 Bulletin 87/36**

(84) Etats contractants désignés:
**DE GB NL**

(71) Demandeur: **THOMSON-CSF**
**173, Boulevard Haussmann**
**F-75379 Paris Cedex 08(FR)**

(72) Inventeur: **Pavlidis, Dimitrios**
**THOMSON-CSF SCPI 19, avenue de Messine**
**F-75008 Paris(FR)**
Inventeur: **Karapiperis, Leonidas**
**THOMSON-CSF SCPI 19, avenue de Messine**
**F-75008 Paris(FR)**

(74) Mandataire: **Taboureau, James et al**
**THOMSON-CSF SCPI 19, avenue de Messine**
**F-75008 Paris(FR)**

(54) Transistor à effet de champ, et circuit intégré logique comportant un tel transistor.

(57) L'invention concerne un transistor à longueur de grille submicronique.

Pour les transistors à longueur de grille sub-micronique, la tension de seuil $V_T$ varie avec la longueur de grille $L_G$, et la caractéristique de transfert du courant drain $I_{DS}$ varie peu avec la tension $V_{GS}$ appliquée sur la grille. Pour obtenir une tension de seuil $V_T$ stable et un effet de princement du canal efficace, il faut optimiser les régions d'accès au canal. Dans le transistor selon l'invention, comportant, sur un substrat (14), une couche active (15) et une grille (16) et deux caissons (17, 18) de prises de contacts sur les source et drain (19, 20), l'accès au canal (15) est optimisé par au moins une région (21 ou 22) de transition progressive de niveau de dopage, depuis le type n à proximité du canal (15) jusqu'au type n⁺ à proximité du caisson (17 ou 18).

Application aux circuits intégrés logiques, dont les transistors ont des tensions de seuils très voisines, et aux circuits hyperfréquences comportant des transistors multidoigts.

FIG_5

## TRANSISTOR A EFFET DE CHAMP, ET CIRCUIT INTEGRE LOGIQUE COMPORTANT UN TEL TRANSISTOR

La présente invention concerne un transistor à effet de champ utilisé dans les circuits intégrés logiques et hyperfréquences, réalisés en matériaux rapides de la famille III-V tels que GaAs ou les alliages similaires. La structure du transistor à effet de champ selon l'invention permet d'obtenir, pour tous les transistors à effet de champ d'un même circuit intégré, une même tension de seuil et de bonnes caractéristiques de pincement du canal, pour des longueurs de grilles submicroniques.

Les circuits intégrés logiques comportent des transistors dont les couches actives sont de type n, de préférence aux couches actives de type p, en raison de la vitesse qui est demandée à ces transistors, parce que les électrons se déplacent plus vite que les trous dans les couches actives. Mais les métallisations de prises de contacts de source et de drain sont déposées sur des couches dopées de type $n^+$ parce que l'adhérence du métal y est meilleure que sur une couche de type n. En outre pour travailler à des fréquences très élevées, en électronique logique, la longueur des grilles, mesurée selon une direction source/drain est submicronique, c'est-à-dire inférieure à un micron. Cependant, il est connu que la tension de seuil $V_T$ varie en fonction de la longueur du canal $L_G$. Cet effet parasite devient sensible lorsque les profondeurs des jonctions entre les caissons qui supportent les métallisations de source et de drain et la couche active sont du même ordre de grandeur que la longueur du canal, dans la couche active. Lorsque la longueur du canal diminue, la proportion de charge controlée par la grille est réduite par effet bidimensionnel, entrainant une variation de la tension de seuil effective du transistor.

Pour remédier à cette variation des tensions de seuil en fonction de la longueur du canal, c'est-à-dire également en fonction de la longueur de la grille, il est connu de réaliser des transistors dont les caissons ou les couches de type $n^+$, qui supportent les métallisations de source et de drain, sont obtenues au moyen de deux diffusions ou implantations, de profils différents, l'implantation la plus profonde se trouvant sous la métallisation, et l'implantation la moins profonde se trouvant à proximité du canal. Des mesures effectuées sur des transistors n'ayant qu'une seule épaisseur d'implantation et sur d'autres ayant des implantations doubles ont montré que les transistors ayant une double implantation ionique présentent une meilleure caractéristique de variation de la tension de seuil en fonction de la longueur de canal. Ceci est la conséquence de la plus faible profondeur de jonction effective près du canal. Par contre, la profondeur de jonction loin du canal, plus importante, permet une prise de contact source/drain sans risque de perçage. Mais cette structure nécessite l'emploi d'au moins deux masques et deux implantations successives, ce qui complique donc la réalisation du transistor et par conséquent la réalisation d'un circuit intégré logique rapide.

Selon l'invention la proportion de charges controlée par la grille est améliorée, parce que la diffusion latérale des donneurs d'électrons depuis les couches ou caissons $n^+$ vers la grille est diminuée, au moyen d'au moins une région de transition progressive, depuis un niveau de dopage de type n à proximité de la grille jusqu'à un niveau de dopage de type $n^+$ à proximité d'au moins un caisson supportant une métallisation de source ou de drain. Il est connu que ces phénomènes se développent préférentiellement entre la grille et le drain, mais bien entendu c'est un avantage de l'invention que de prévoir deux régions de transitions progressives placées entre la grille d'une part, et les régions de source et de drain d'autre part. On obtient ainsi des transistors avec une tension de seuil qui dépend peu de la longueur de grille, et dont le canal peut être pincé efficacement.

Ces régions de transitions progressives sont obtenues par l'utilisation d'un faisceau d'ions focalisé qui permet d'implanter des ions sélectivement dans des bandes parallèles de faible largeur, de l'ordre de 1000 angströms, dans au moins l'une des deux régions de matériau comprises entre grille et source, et/ou entre grille et drain, de telle sorte que le niveau de dopage augmente depuis le canal dopé n, sous la grille, vers les couches ou caissons de prises de contact dopés $n^+$, sous la source et/ou le drain. L'implantation se fait à faible énergie et faible dose à proximité du canal, et augmente de façon continue, en énergie et en dose, en se rapprochant des zones de prises de contacts.

De façon plus précise, l'invention concerne un transistor à effet de champ, comportant, supporté par un substrat, au moins une couche active, en matériau semiconducteur de type n, formant un canal sous l'électrode de grille, et une couche en matériau dopé de type $n^+$, formant deux caissons de prises de contacts sous les électrodes de source et de drain, ce transistor étant caractérisé en ce que, en vue de diminuer la diffusion latérale des donneurs d'électrons depuis les caissons de la couche dopée $n^+$ vers le canal dopé n, il comporte, entre ledit canal et au moins l'un des deux caissons de prises de contacts, au moins une région dans laquelle le matériau semiconducteur est dopé de façon progressive depuis le type n, à proximité du canal, jusqu'au type n+, à proximité d'un caisson de prise de contact.

L'invention sera mieux comprise par la description de deux exemples de réalisation de transistors de type MESFET c'est-à-dire Métal-Semiconducteur ou de type MOSFET c'est-à-dire Métal-Oxyde-Semiconducteur, cette description s'appuyant sur les figures jointes en annexes qui représentent :

-Figure 1 : coupe schématique de la région de canal d'un transistor MESFET, selon l'art connu,

-Figure 2 : courbe donnant la variation de la tension de seuil $V_T$ en fonction de la longueur de grille $L_G$ dans un MESFET,

-Figure 3 : performance de rapidité d'un MESFET en fonction de la longueur de grille $L_G$,

-Figure 4 : courbe du courant drain en fonction de la tension de grille pour un MESFET,

-Figure 5 : coupe schématique de la région de canal d'un MESFET selon l'invention,

-Figure 6 : coupe schématique de la région de canal d'un MOSFET selon l'art connu, en situation de perçage (punch through),

-Figure 7 : coupe schématique de la région du canal d'un MOSFET selon l'invention,

-Figure 8 : courbes comparées de la variation de la tension de seuil en fonction de la longueur de grille, pour un transistor selon l'art connu et un transistor selon l'invention.

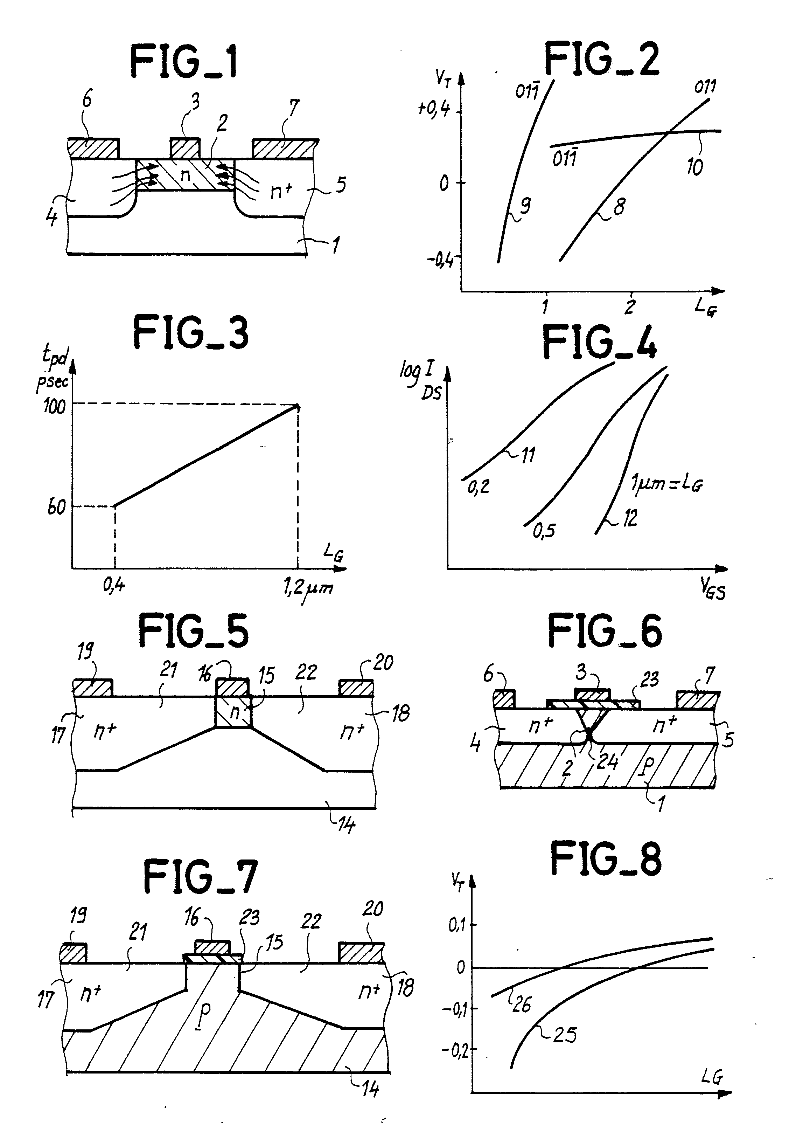

La figure 1 est une coupe schématique de la région du canal d'un transistor à effet de champ de type MESFET, selon l'art connu : ce schéma et les rappels correspondants permettront de mieux comprendre le problème résolu par le transistor selon l'invention.

Un transistor à effet de champ comporte au moins un substrat 1, en matériau semi-isolant très généralement, qui supporte au moins une couche dite active, dans laquelle est délimitée une région de canal 2 de type de conductivité n : le passage du courant dans le canal 2 est controlé par une électrode de grille 3, et les régions d'accès au canal sont des régions ou des caissons de type n+ qui supportent des électrodes de source et de drain 6 et 7.

Un transistor à effet de champ a une tension de seuil $V_T$, qui est la tension appliquée sur la grille en dessous de laquelle le passage du courant dans le canal n'est pas contrôlé. La dispersion de la tension de seuil $V_T$ sur une plaquette de matériau semiconducteur utilisée pour la fabrication collective de circuits intégrés logiques dépend de l'homogénéité de la plaquette ainsi que de la dispersion des longueurs de grille $L_G$ des transistors à effet de champ. La plaquette n'est pas rigoureusement homogène, en ce sens qu'elle comporte toujours des irrégularités dans les niveaux de dopage du matériau livré par le fondeur de GaAs, des défauts cristallo graphiques, et les longueurs de grille connaissent également une certaine dispersion due à la non reproductibilité totale des masques de fabrication.

Par ailleurs les caissons n+, qui sont d'avantage dopés que le canal n ont tendance à fournir des électrons au canal : la diffusion latérale des donneurs d'électrons, depuis les caissons 4 et 5 vers le canal 2, au-dessous de la grille des transistors à effet de champ, cause souvent un faible rendement de fabrication pour les circuits intégrés logiques, en raison de la forte dépendance de la tension de seuil $V_T$ par rapport à la longueur de grille $L_G$. Selon la méthode de lithographie utilisée pour réaliser les circuits intégrés, l'homogénéité et la reproctubilité des longueurs de grille peuvent varier sur une plaque, donnant lieu à une variation de tension de seuil $V_T$ plus ou moins importante. Une solution, applicable aux transistors auto-alignés, consiste à sélectionner l'orientation des grilles par rapport à l'axe cristallographique du substrat utilisé. Lors du recuit des plaques, les contraintes à l'interface entre la couche d'encapsulation diélectrique et le matériau semiconducteur GaAs favorisent une diffusion excessive pour des grilles orientées [0 1 1] ; en choisissant une orientation [ 0 1 $\overline{1}$ ] ce phénomène est moins prononcé pour les grilles de longueurs supérieures à un micron ; néanmoins dans le cas des grilles submicroniques la diffusion excessive a lieu indépendamment de l'orientation.

C'est ce que représente la figure 2 dans laquelle les longueurs de grille $L_G$ sont portées en abscisse tandis que les tensions de seuil $V_T$ sont portées en ordonnée. La courbe 8 représente le cas d'un transistor à effet de champ dont la grille est orientée selon l'axe cristallographique [0 1 1] : la tension de seuil de ce transistor varie fortement en fonction de sa longueur de grille. Pour un transistor dont la grille est orientée selon l'axe cristallographique [ 0 1 $\overline{1}$ ], tel qu'en courbe 9, la tension de seuil varie beaucoup plus si la longueur de grille est inférieure à un micron. Ceci est un inconvénient puisqu'on sait que pour des circuits la fréquence de coupure d'un transistor est une fonction de sa longueur de grille, mais par contre les tensions de seuil ne sont pas régulières sur un circuit intégré puisqu'une faible variation de longueur de grille amène une forte variation de tension de seuil. L'objectif à atteindre est celui qui est représenté par la courbe 10, et qui est d'ailleurs obtenu par le transistor selon l'invention : une forte variation de longueur de grille n'entraine qu'une très faible variation de la tension de seuil.

Une conséquence de la variation de la tension de seuil avec la longueur de grille est que pour une dispersion donnée de la longueur de grille $L_G$, cette dispersion étant imposée par les limites de la technologie de masquage, on peut améliorer le rendement de fabrication de circuits intégrés logiques hyperfréquences en optimisant chaque transistor pour avoir une tension de seuil qui dépend peu de la longueur de grille : ceci est possible en augmentant la longueur de grille, ou en éloignant les zones de contacts $n^+$ du canal n, respectivement 2, 4 et 5 sur la figure 1. La première approche se fait au détriment de la performance du transistor et par conséquent du circuit intégré, et elle est représentée par la figure 3 sur laquelle on voit que le temps de basculement $t_{pd}$ d'un transistor est une fonction, bien connue d'ailleurs, de la longueur de grille. La seconde approche, qui consiste à éloigner les zones de contacts de la couche active risque d'augmenter les résistances d'accès au canal.

Par ailleurs la figure 4 rappelle une caractéristique connue des transistors à canal court. Sur cette figure, dans laquelle le logarithme du courant drain-source $I_{DS}$ est porté en fonction de la tension grille-source $V_{GS}$, on voit que pour une grille de 0,2 micron de longueur, correspondant à la courbe 11, la variation du courant drain $I_{DS}$ est relativement "molle" en fonction de la variation de la tension appliquée sur la grille, alors que pour une grille de longueur d'un micron, correspondant à la courbe 12, cette variation est beaucoup plus rapide. C'est un phénomène de canal court, qui impose des caractéristiques de transferts $I_{DS}$-$V_{GS}$ douces, ce qui empêche le bon pincement du canal. En d'autres termes si dans un circuit intégré il y a une certaine dispersion de longueur de grille pour les transistors du circuit intégré, tous ces transistors ne pincent pas le canal de la même façon pour une même tension appliquée sur leur grille et il y a donc une inhomogénéité dans le circuit intégré et une faible transconductance $g_m$ dans le cas des caractéristiques douces. Il est bien entendu qu'un circuit intégré fonctionnera d'autant mieux que tous ses transistors ont la même caractéristique de transfert, de préférence une caractéristique telle que celle de la courbe 12, mais pour une longueur de grille submicronique de l'ordre de 0,2 ou 0,5 micron par exemple.

C'est donc un objet de l'invention que d'obtenir des transistors, dans des circuits intégrés, qui aient une faible dépendance de la tension de seuil en fonction de la longueur de grille, et une forte dépendance du courant drain-source en fonction de la tension de grille, pour des longueurs de grille submicroniques.

Le transistor à effet de champ selon l'invention, resprésenté en figure 5, permet d'obtenir ces résultats, grâce à sa structure.

Il comporte au moins un substrat 14, en matériau semi-isolant par exemple, qui supporte au moins une couche active 15, ou canal, en matériau de type n, commandé par une métallisation de grille 16. L'accès au canal a lieu au moyen de deux couches ou caissons de type $n^+$, 17 et 18, qui supportent les deux métallisations 19 et 20 de source et de drain. Bien entendu, des structures plus complexes que celle-ci, comportant par exemple une pluralité d'hétérojonctions ou des couches de lissage, appartient au domaine de l'invention. Ce qui permet au transistor selon l'invention d'avoir une faible dépendance de la tension de seuil en fonction de la longueur de grille et une forte dépendance du courant drain/source en fonction de la tension de grille est le fait qu'il comprend au moins une région, mais de préférence deux régions, de transitions progressives depuis le type n jusqu'au type $n^+$, ces deux régions 21 et 22 étant implantées entre le canal 15 d'une part et les caissons 17 et 18 de source et de drain.

La couche active du transistor à effet de champ est réalisée par implantation d'ions à l'aide d'un faisceau d'ions focalisé. On peut implanter des ions de silicium ou de beryllium avec des énergies et à des doses qui vont depuis 50 KeV à proximité du canal 15, jusque 250 KeV jusqu'à proximité des caissons 17 et 18, les doses étant de $10^{12}$ ions/cm² à proximité du canal jusque $5.10^{13}$ ions/cm² à proximité des caissons 17 et 18. L'implantation des régions de transition 21 et 22 est donc plus profonde à proximité des caissons 17 et 18. L'intérêt de cette méthode de faisceau d'ions focalisé est qu'elle permet d'implanter sans masquage sur des bandes extrêmement minces, de l'ordre de 1000 angströms de largeur, les bandes étant parallèles aux métallisations de source, de grille et de drain, c'est-àdire perpendiculaires au plan de la figure 5. Il est donc possible, en augmentant progressivement l'énergie d'implantation dans le sens de la grille vers la source ou de la grille vers le drain de maitriser le phénomène de diffusion latérale excessive des donneurs d'électrons et de réaliser des transistors ayant une faible dépendance de la tension de seuil en fonction de la longueur de grille, et dont le canal est bien pincé.

Puisque l'utilisation des faisceaux d'ions focalisés permet d'augmenter progressivement, c'est-à-dire de façon continue ou quasi-continue, l'énergie d'implantation dans la zone grille-source 21 ou grille-drain 22, on évite ainsi une forte diffusion latérale excessive des donneurs d'électrons, contenus dans les caissons $n^+$ 17 et 18, vers la partie du canal 15 qui est sous la grille. Cette diffusion qui se manifeste dans le cas de réalisation de couches actives n/n⁺ dont les énergies sont très différentes, n'a plus de raison d'être puisque l'énergie de la couche dopée n évolue de façon continue jusqu'au niveau d'énergie de la couche dopée n⁺.

En outre, en appliquant la technique des faisceaux d'ions focalisés, on peut optimiser les zones d'accès du canal, donc les zones de transitions 21 et 22, et réduire les phénomènes illustrés par la figure 4 de caractéristiques de transfert $I_{DS}/V_{GS}$ : il est donc possible pour un transistor ayant une longueur de grille aussi courte que 0,2 micron d'obtenir une caractéristique de transfert $I_{DS}/V_{GS}$ brutale, c'est-à-dire d'obtenir une forte dépendance du courant drain-source en fonction de la tension de grille.

La figure 6 représente la coupe schématique de la région de canal d'un MOSFET selon l'art connu. Ce transistor de type MOS a, grossièrement, la même structure que le transistor de type MES représenté en figure 1, mais la métallisation de grille 3 est déposée sur une couche d'oxyde 23, qui elle-même repose sur la région de canal 2 de type p comme le substrat. Le risque avec les transistors de type MOS est que, en diminuant la longueur de grille, les zones déplétées à l'interface des couches n⁺-p de source et de drain se rapprochent avec risque de perçage, plus connu sous le nom de "punch through", tel que représenté sur la figure 6. Les zones déplétées s'étant rapprochées l'une de l'autre sous l'effet des tensions de polarisation, elle peuvent finalement entrer en contact réciproque dans la région 24 du canal.

On peut réduire la zone déplétée en diminuant la tension de drain $V_D$ et en augmentant le dopage des couches n⁺. Pour une tension de drain donnée, on choisit la plus mince couche d'oxyde possible pour pouvoir inverser facilement le canal sans claquage d'oxyde, puis on augmente le dopage du canal jusqu'à ce que l'on ait atteint une tension de seuil $V_T$ égale à $V_D/k$, k étant une constante égale à 2, 3 etc... selon la conception du circuit. Pour le dopage choisi, on peut évaluer les zones déplétées et la longueur minimale permise.

C'est ce qui est représenté en figure 7, qui donne la coupe schématique dans la région du canal d'un transistor MOSFET selon l'invention. De même que le MOS de la figure 6 était à l'image du MES de la figure 1, le MOS selon l'invention de la figure 7 est à l'image du MES selon l'invention de la figure 5, c'est-à-dire qu'il comporte en plus une couche d'oxyde 23 disposée entre la métallisation de grille 16 et la couche active ou de canal 15. Les deux régions 21 et 22 de matériau semiconducteur qui sont situées entre la couche active 15 et les caissons n⁺ 17 et 18 sont implantées, avec augmentation progressive d'énergie et de dose au fur et à mesure que l'on s'éloigne de la grille pour se rapprocher de la source et du drain. L'augmentation progressive du dopage du canal vers les contacts de source et de drain par implantation au moyen d'un faisceau d'ions focalisé permet de diminuer les zones déplétées et d'éviter ainsi le phénomène de "punch through" ce qui permet de réaliser des transistors à géométrie plus fine.

La figure 8 représente les courbes comparées de tensions de seuil $V_T$, en ordonnée, en fonction des longueurs de grille $L_G$, en abscisse, pour un transistor selon l'art connu, à jonctions n-n⁺ abruptes, et pour un transistor selon l'invention, à régions de transition dont le dopage est progressif.

La courbe 25, qui correspond à un transistor selon l'art connu, présente une forte variation de $V_T$ lorsque la longueur de grille devient inférieure à 1 micron environ, ce qui a été déjà montré en figure 2, avec les courbes 8 et 9. Il est donc difficile de réaliser des circuits intégrés dont tous les transistors, de longueurs de grilles submicroniques, aient la même tension de seuil $V_T$.

Par contre, la courbe 26, qui correspond à un transistor selon l'invention, montre que la tension de seuil varie peu lorsque la longueur de grille diminue. Il est donc possible de faire des circuits intégrés dont tous les transistors ont sensiblement la même tension de seuil $V_T$, même si les longueurs de grille varient un peu selon le masquage.

Bien que l'invention ait été décrite en s'appuyant sur le cas d'un transistor, il est bien entendu qu'elle trouve essentiellement son application dans le cas de circuits intégrés hyperfréquences logiques, pour lesquels les transistors d'un même circuit intégré ont donc grâce à l'invention des caractéristiques améliorées, et proches les unes des autres, la structure selon l'invention permettant de diminuer les dispersions de tensions de seuil des transistors d'un même circuit intégré.

Bien entendu, l'invention n'est pas limitée aux modes de réalisation décrits et représentés, et comprend tous les équivalents techniques des moyens décrits ainsi que leurs combinaisons si celles-ci sont effectuées suivant l'esprit de l'invention et mises en oeuvre dans le cadre des revendications qui suivent.

## Revendications

1. Transistor à effet de champ, comportant, supporté par un substrat (14), au moins une couche active (15), en matériau semiconducteur de type n, fromant un canal sous l'électrode de grille (16), et une couche en matériau dopé de type n⁺, formant deux caissons (17, 18) de prises de contacts sous les électrodes de source et de drain (19, 20), ce transistor étant caractérisé en ce que, en vue de diminuer la diffusion latérale des donneurs d'électrons depuis les caissons (17, 18) de la couche dopée n⁺ vers le canal (15) dopé n, il comporte, entre ledit canal (15) et au moins l'un des deux caissons (17, 18) de prises de contacts, au moins une région (21 ou 22) dans laquelle le matériau semiconducteur est dopé de façon progressive depuis le type n, à proximité du canal - (15), jusqu'au type n⁺, à proximité d'un caisson (17 ou 18) de prise de contact.

2. Transistor à effet de champ selon la revendication 1, caractérisé en ce que la transition du niveau de dopage, dans la région (21 ou 22) située entre canal (15) et caisson (17 ou 18) de prise de contact est continue, ou quasi continue, par bandes de 1000 angströms de largeur, parallèles aux métallisations de source, de grille et de drain (19, 16, 20).

3. Transistor à effet de champ selon la revendication 1, caractérisé en ce que la région de transition (21 ou 22) entre canal (15) et caisson (17 ou 18) de prise de contact est dopée, par implantation par faisceau d'ions focalisé, avec une énergie variant de 150 KeV jusque 250 KeV et à des doses variant de $5.10^{12}$ ions/cm² jusque $2.10^{13}$ ions/cm², respectivement à proximité du canal (15) (dopage n) et à proximité du caisson (17 ou 18) (dopage n⁺).

4. Transistor à effet de champ selon la revendication 3, caractérisé en ce que la région de transition (21 ou 22) entre canal (15) et caisson (17 ou 18) a à proximité du caisson (17 ou 18) où elle est implantée sous forte énergie, une épaisseur supérieure à l'épaisseur qu'elle a à proximité du canal (15) où elle est implantée sous moins forte énergie.

5. Transistor à effet de champ selon la revendication 1, caractérisé en ce que sa tension de seuil $V_T$ dépend peu de sa longueur de grille $L_G$, pour une longueur de grille sub-micronique.

6. Transistor à effet de champ selon la revendication 1, caractérisé en ce que sa caractéristique de transfert de courant drain-source $I_{DS}$ dépend fortement de sa tension de grille $V_{GS}$, pour une longueur de grille sub-micronique.

7. Circuit intégré hyperfréquence logique, caractérisé en ce qu'il comporte au moins deux transistors à effet de champ selon la revendication 1.

FIG_1

FIG_2

FIG_3

FIG_4

FIG_5

FIG_6

FIG_7

FIG_8